# EUROPEAN PATENT SPECIFICATION

(11) **EP 3 767 004 B1**
(45) Date of publication and mention of the grant of the patent: **27.09.2023**
(21) Application number: 19186683.9
(22) Date of filing: 17.07.2019
(51) Int. Cl.: C23C 14/24

(54) **EVAPORATION BOAT FOR EVAPORATION OF METALS**
VERDAMPFERSCHIFF ZUM VERDAMPFEN VON METALLEN
BATEAU D'ÉVAPORATION POUR ÉVAPORATION DE MÉTAUX

(43) Date of publication of application: 20.01.2021
(73) Proprietor: 3M Innovative Properties Company, Saint Paul, MN 55133-3427 (US)
(72) Inventor: Victor, Georg, 87487 Wiggensbach (DE); Ruisinger, Bernd, 79104 Freiburg (DE); Fundus, Michael, 87437 Kempten (DE)
(74) Representative: Mössner, Brigitte

(56) References cited:
- WO-A1-2004/063419
- DE-B- 1 207 179
- US-A1- 2007 110 412
- US-A1- 2016 208 373

## Description

### Technical Field

The present disclosure relates to an evaporation boat for evaporation of metals.

### Background

The most common method for coating flexible substrates such as polymeric films or papers with metals is the so-called vacuum web coating using physical vapor depositing technology. The coated flexible substrates serve a wide field of applications such as food packaging, for decorative purposes and manufacturing of capacitors.

In vacuum web coaters, the substrate to be coated is passed over a cooled metal drum where it is exposed to metal vapor. Thus, the metal is deposited in a thin layer on the substrate.

To create the required constant metal vapor, a series of ceramic evaporation boats, aligned along the entire width of the film to be coated, are placed in cooled copper clamps and heated up by direct current flow in a vacuum of typically 10⁻⁴ mbar to temperatures of 1400 - 1550 °C. Metal wire is continuously fed to the surface of the evaporation boat where it is melted and vaporized. The most common metal used in this process is aluminum. The ceramic evaporation boat typically consists of a mixture of titanium diboride (TiB₂) and boron nitride (BN), sometimes aluminum nitride (AIN) is used in addition. Typically, the cross-sectional area of the evaporation boat is rectangular.

One major drawback of the process is the low energy efficiency. Only about 10 to 15% of the total electrical energy which is fed to the evaporation boat is used for vaporizing the metal. Major losses of energy stem from losses by cooling of the end areas of the boat in the copper clamps and from losses by heat radiation. Total energy costs of the vacuum web coating process equal to about 20 to 25% of the overall coating costs.

Several possibilities have been described to improve the energy efficiency of the vacuum web coating process.

DE 19708599 C1 discloses an evaporation boat having a triangular cross-sectional area. Compared to an evaporation boat with rectangular cross section, the radiating surface area is reduced.

US 6,085,025 discloses an evaporation boat with a cross-sectional area in the shape of a halved ellipse. Energy savings compared to an evaporation boat with rectangular cross section could be achieved.

DE 20309444 U1, DE 20300167 U1 and WO 2004063419 A1 disclose an evaporation boat having a trapezoidal cross-sectional area. The lateral side surfaces of the evaporation boat are inclined to enclose an angle of 45° with the upper side surface. A more stable and more quiet operational behavior and lower production costs are stated as main benefits.

US 2016/208373 A1 discloses an evaporator boat assembly comprising an evaporator boat, the evaporator boat comprising a top surface defining a pool, and a thermal insulation package comprising a thermal insulation body wherein the thermal insulation body contains a cavity, the evaporator boat being remobably received within a cavity, and the evaporator boat being operatively connected to a heater.

DE 1207179 B discloses a crucible made from an oxide ceramic material which essentially consists of calcium oxide. This ceramic material is not electrically conductive, the crucible is heated up by an external induction coil. The crucible is not heated up by direct current flow.

US 2007/110412 A1 discloses an evaporation boat with a plurality of grooves on the upper surface of the evaporation boat. Each of the grooves has a depth of at least 1.2 mm, a width of at least 1.75 mm, and an interval spacing of at least 2.2 mm, and at least two of the grooves have at least 20% of length at an angle of 10 to 170 degrees to the direction of electrical conduction of the evaporation boat. The cross-sectional area of the evaporation boat is primarily rectangular.

There is still a need to further improve evaporation boats for evaporation of metals with respect to energy efficiency during operation in the vacuum web coating process.

As used herein, "a", "an", "the", "at least one" and "one or more" are used interchangeably. Adding an "(s)" to a term means that the term should include the singular and plural form. The term "comprise" shall include also the terms "consist essentially of" and "consists of".

### Summary

In a first aspect, the present disclosure relates to an evaporation boat for evaporation of metals, wherein the evaporation boat is made from a material comprising titanium diboride and boron nitride, and wherein the evaporation boat has an upper side, an underside, two lateral surfaces and two clamping surfaces, and wherein metal is evaporated from the upper side, and wherein the two clamping surfaces are parallel to each other, and wherein at least one part of the evaporation boat has a cross-sectional area with a trapezoidal shape in a direction parallel to the clamping surfaces, and wherein the upper side of the evaporation boat is parallel to the underside of the evaporation boat, characterized in that each of the two lateral surfaces of the evaporation boat is inclined at an angle of from 30 to 42 degrees against the upper side of the evaporation boat in the at least one part of the evaporation boat having a cross-sectional area with a trapezoidal shape.

In another aspect, the present disclosure also relates to the use of the evaporation boat disclosed herein for evaporating metals selected from the group consisting of aluminum, copper and silver.

With the evaporation boat of the present disclosure, the power consumption during the web coating process is reduced, compared to standard evaporation boats with rectangular cross-sectional area. Surprisingly, power consumption during the web coating process is reduced also compared to evaporation boats with trapezoidal cross-sectional area with a trapezoid angle of 45°. In some embodiments of the present disclosure, about 3 to 8% of the total electrical energy which is fed to the evaporation boat can be saved, compared to evaporation boats with trapezoidal cross-sectional area with a trapezoid angle of 45°.

The evaporation boat of the present disclosure can be used in vacuum web coaters with standard clamping devices without the need of design changes in the clamping area.

### Brief description of the drawings

The present disclosure is explained in more detail on the basis of the drawings, in which:
Figures 1 and 2 show various views of an evaporation boat as disclosed herein;
Figures 3 and 4 show various views of an evaporation boat as disclosed herein;
Figure 5 shows a longitudinal view of the evaporation boat of Figures 3 and 4;
Figures 6 and 7 show longitudinal views of evaporation boats as disclosed herein;
Figure 8 shows a plan view of the upper side of the evaporation boats of Figures 5 to 7;
Figure 9 and 10 show various views of an evaporation boat as disclosed herein;
Figures 11A - 11C show various views of an evaporation boat as disclosed herein;
Figures 12 and 13 show various views of an evaporation boat as disclosed herein;
Figure 14 shows a plan view of the upper side of an evaporation boat as disclosed herein; and
Figure 15 shows a plan view of the upper side of an evaporation boat as disclosed herein.

### Detailed Description

The evaporation boat as disclosed herein has an upper side, an underside, two lateral surfaces and two clamping surfaces. Metal is evaporated from the upper side. The clamping surfaces, when placed into a vacuum web coater, are in contact with the copper clamps which provide electrical current supply to the evaporation boat. The two clamping surfaces are parallel to each other.

At least one part of the evaporation boat as disclosed herein has a cross-sectional area with a trapezoidal shape. The cross-sectional area with a trapezoidal shape is in a direction parallel to the clamping surfaces. The upper side of the evaporation boat is parallel to the underside of the evaporation boat. Each of the two lateral surfaces of the evaporation boat is inclined at an angle of from 30 to 42 degrees against the upper side of the evaporation boat in the at least one part of the evaporation boat having a cross-sectional area with a trapezoidal shape.

In some embodiments of the evaporation boat as disclosed herein, each of the two lateral surfaces of the evaporation boat is inclined at an angle of from 30 to 40 degrees against the upper side of the evaporation boat in the at least one part of the evaporation boat having a cross-sectional area with a trapezoidal shape.

For example, each of the two lateral surfaces of the evaporation boat may be inclined at an angle of 30°, or at an angle of 32°, or at an angle of 35°, or at an angle of 38°, or at an angle of 40°, or at an angle of 42° against the upper side of the evaporation boat in the at least one part of the evaporation boat having a cross-sectional area with a trapezoidal shape.

The evaporation boat according to the present disclosure has a length, a width and a height. As used herein, the width of the evaporation boat is the width at the upper side of the evaporation boat. In some embodiments of the evaporation boat as disclosed herein, the cross-sectional area of the evaporation boat has a trapezoidal shape in a direction parallel to the clamping surfaces along the complete length of the evaporation boat. This means that all parts of the evaporation boat have a cross-sectional area with a trapezoidal shape in a direction parallel to the clamping surfaces, i.e. the complete evaporation boat has a cross-sectional area with a trapezoidal shape in a direction parallel to the clamping surfaces.

The evaporation boat as disclosed herein comprises two clamping regions adjacent to the clamping surfaces and a central region in a middle part of the evaporation boat between the two clamping regions. Metal is evaporated from the upper side of the central region. In some embodiments of the evaporation boat as disclosed herein, the at least one part of the evaporation boat having a cross-sectional area with a trapezoidal shape in a direction parallel to the clamping surfaces is in the central region of the evaporation boat, i.e. the cross-sectional area in the central region has a trapezoidal shape in a direction parallel to the clamping surfaces.

In some embodiments of the evaporation boat as disclosed herein, the cross-sectional area in the two clamping regions may have a rectangular shape in a direction parallel to the clamping surfaces.

The evaporation boat as disclosed herein may have a length of from 90 to 170 mm, a width at the upper side of from 15 to 50 mm, and a height of from 6 to 12 mm.

In some embodiments of the evaporation boat as disclosed herein, one of the two lateral surfaces of the evaporation boat is inclined at an angle α against the upper side of the evaporation boat in the at least one part of the evaporation boat having a cross-sectional area with a trapezoidal shape, and the other one of the two lateral surfaces of the evaporation boat is inclined at an angle β against the upper side of the evaporation boat in the at least one part of the evaporation boat having a cross-sectional area with a trapezoidal shape, and α is equal to β.

In some embodiments of the evaporation boat as disclosed herein, one of the two lateral surfaces of the evaporation boat is inclined at an angle α against the upper side of the evaporation boat in the at least one part of the evaporation boat having a cross-sectional area with a trapezoidal shape, and the other one of the two lateral surfaces of the evaporation boat is inclined at an angle β against the upper side of the evaporation boat in the at least one part of the evaporation boat having a cross-sectional area with a trapezoidal shape, and α is different from β.

The evaporation boat as disclosed herein allows energy savings as less material has to be heated up and to be maintained at operating temperature. Furthermore, a uniform temperature of the upper side where metal is evaporated from is achieved. This is also due to an advantageous ratio of area of radiating surfaces to boat volume.

The radiating surface of the evaporation boat is the surface which is not in contact with molten metal to be evaporized. As used herein, the radiating surface is composed of the two lateral surfaces and the underside of the evaporation boat.

The ratio of area of radiating surfaces to boat volume is hereinafter also referred to as surface to volume ratio.

The total volume of the evaporation boat as disclosed herein is lower than the total volume of an evaporation boat with a rectangular cross-sectional area and with the same height and with an upper side having the same width, and it is also lower than the total volume of an evaporation boat with a trapezoidal cross-sectional area and a trapezoidal angle of 45° and with the same height and with an upper side having the same width. As a consequence, less material needs to be heated up and less heat is produced. Although the radiating surface of the evaporation boat as disclosed herein is smaller than the radiating surface of an evaporation boat with a rectangular cross-sectional area and with the same height and with an upper side having the same width, the ratio of radiating surface to boat volume of the evaporation boat as disclosed herein is higher than for an evaporation boat with a rectangular cross-sectional area and with the same height and with an upper side having the same width, and the ratio of radiating surface to boat volume of the evaporation boat as disclosed herein is also higher than the surface to volume ratio of an evaporation boat with a trapezoidal cross-sectional area and a trapezoidal angle of 45° and with the same height and with an upper side having the same width. As a consequence, a better control of the temperature distribution along the length and width of the upper side of the evaporation boat is achieved which leads to a more uniform temperature distribution of the upper side, resulting in a larger pool of liquid metal on the upper side and an improved wetting behavior.

For an evaporation boat having boat dimensions of 130 mm x 35 mm x 9 mm, the surface to volume ratio of the evaporation boat as disclosed herein is more than 1.81. For an evaporation boat with these dimensions, the surface to volume ratio of the evaporation boat as disclosed herein is at most 2.28.

The evaporation boat as disclosed herein may have a flat upper side from which metal is evaporated.

The evaporation boat as disclosed herein may have also a cavity on the upper side of the evaporation boat. The cavity takes the liquid metal pool, and metal is evaporated from the cavity. The cavity usually does not extend to the regions near the clamping surfaces, i.e. the clamping regions.

The upper side of the evaporation boat as disclosed herein may have a structured surface to allow a uniform distribution of the liquid metal pool. The upper side of the evaporation boat as disclosed herein may also have a structured surface for helping to avoid that liquid metal flows into the clamping regions. The structured surface may be obtained by mechanical machining or by treatment with a high-energy beam. Examples of such structured surfaces are explained below in more detail.

The upper side of the evaporation boat as disclosed herein may have one or more grooves in a direction parallel to the clamping surfaces. In some embodiments, these grooves are near the clamping regions. The number of grooves near the clamping regions may be one or two or three, for example. The number of grooves near one of the two clamping regions may be different from the number of grooves near the other one of the two clamping regions. The evaporation boat with grooves near the clamping regions may have a cavity. If the evaporation boat has a cavity, the grooves near the clamping regions are outside the cavity. The evaporation boat with grooves near the clamping regions may also have no cavity. At the positions of the grooves near the clamping regions, the temperature of the evaporation boat during operation is higher than in the central region of the evaporation boat, with the consequence that metal is evaporated at the positions of the grooves before flowing into the clamping regions. The one or more grooves may have a depth of from 2 to 5 mm and a width of from 2 to 10 mm.

In some embodiments, the grooves in a direction parallel to the clamping surfaces may extend over the central region of the upper side, or over the complete upper side of the evaporation boat. These grooves serve for improving the initial wetting behavior of the evaporation boat with molten metal. Typically, these grooves have a depth of up to 1 mm and a width of from 0.5 mm to 1 mm.

In some embodiments, the evaporation boat as disclosed herein may have a plurality of grooves in a direction not parallel to the clamping surface and not parallel to the lateral surfaces. These grooves serve for improving the initial wetting behavior of the evaporation boat with molten metal. Typically, these grooves have a depth of up to 1 mm and a width of from 0.5 mm to 1 mm.

In some embodiments of the evaporation boat as disclosed herein, the upper side of the evaporation boat has a peripheral groove which is oriented parallelly to the lateral surfaces and parallelly to the clamping surfaces. The peripheral groove may have a depth of from 2 to 5 mm and a width of from 1 to 5 mm. In the surface area enclosed by the peripheral groove, a homogeneous and complete wetting with molten metal is achieved in a defined surface area on the upper side of the evaporation boat from which metal is evaporated.

In some embodiments of the evaporation boat as disclosed herein, the upper side of the evaporation boat is modified by a laser beam. By a laser beam, the upper side of the evaporation boat may be structured. For example, the upper side of the evaporation boat may be structured by a laser beam in such a way that a plurality of lines with a direction substantially parallel to the lateral surfaces extends over the upper side of the evaporation boat. The modification of the upper side of the evaporation boat by a laser beam is improving the initial wetting behavior of the evaporation boat with molten metal.

The upper side of the evaporation boat as disclosed herein may be coated at least partially with an inorganic material. The coating with the inorganic material may serve for improving the initial wetting of the surface with molten metal. The inorganic material may be applied as slurry, paste or granules by customary methods such as painting, brushing and spraying. The inorganic material may comprise metals such as titanium, zirconium, tungsten and molybdenum, nitrides such as boron nitride, aluminum nitride, titanium nitride and zirconium nitride, borides such as aluminum borides, titanium diboride, zirconium diboride, tungsten borides and molybdenum borides, or combinations thereof. Typically, the coating with the inorganic material has a thickness of 2 to 100 µm.

The evaporation boat as disclosed herein is heated up by direct current flow.

Various embodiments of the evaporation boat according to the present disclosure are shown in the drawings.

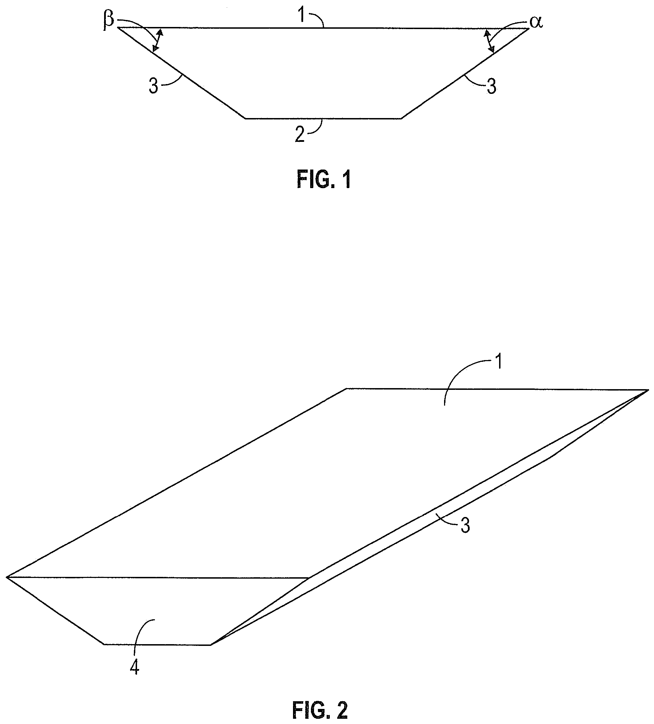

Figure 1 shows a cross-sectional view of an evaporation boat as disclosed herein, in a direction parallel to the clamping surfaces. Figure 1 also shows the plan view of the clamping surfaces of the evaporation boat. Figure 2 shows a 3D view of the evaporation boat of Figure 1. Metal is evaporated from the upper side 1. The cross-sectional area of the evaporation boat has a trapezoidal shape in a direction parallel to the clamping surfaces along the complete length of the evaporation boat. The upper side 1 of the evaporation boat is parallel to the underside 2 of the evaporation boat. The two clamping surfaces 4 of the evaporation boat are parallel to each other. Each of the two lateral surfaces 3 of the evaporation boat is inclined at an angle α and at an angle β, respectively, of from 30 to less than 45 degrees against the upper side 1 of the evaporation boat. In the example of Figures 1 and 2, the angle α is equal to the angle β and is 35°.

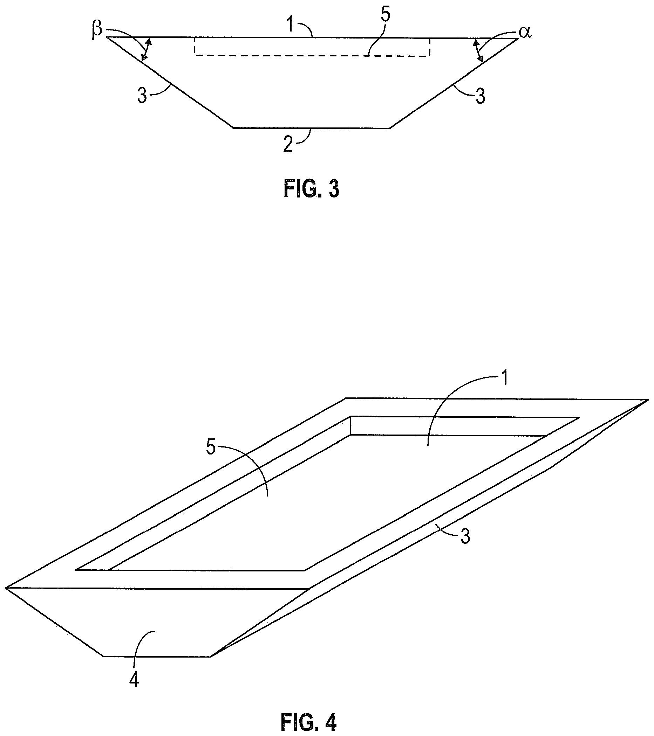

Figure 3 shows the plan view of the clamping surfaces of a further embodiment of an evaporation boat as disclosed herein. Figure 4 shows a 3D view of the evaporation boat of Figure 3. The plan view of the clamping surfaces has a trapezoidal shape. The evaporation boat of Figures 3 and 4 has a cavity for the liquid metal in the central region of the evaporation boat. This is indicated in Figure 3 by the dotted line and can be seen from Figure 4. Metal is evaporated from the upper side 1, i.e. from the cavity 5. The cross-sectional area of the evaporation boat has a trapezoidal shape in the clamping regions of the evaporation boat. The clamping regions are adjacent to the clamping surfaces 4. The two clamping surfaces 4 of the evaporation boat are parallel to each other. The upper side 1 of the evaporation boat is parallel to the underside 2 of the evaporation boat. Each of the two lateral surfaces 3 of the evaporation boat is inclined at an angle α and at an angle β, respectively, of from 30 to less than 45 degrees against the upper side 1 of the evaporation boat. In the example of Figures 1 and 2, the angle α is equal to the angle β and is 35°.

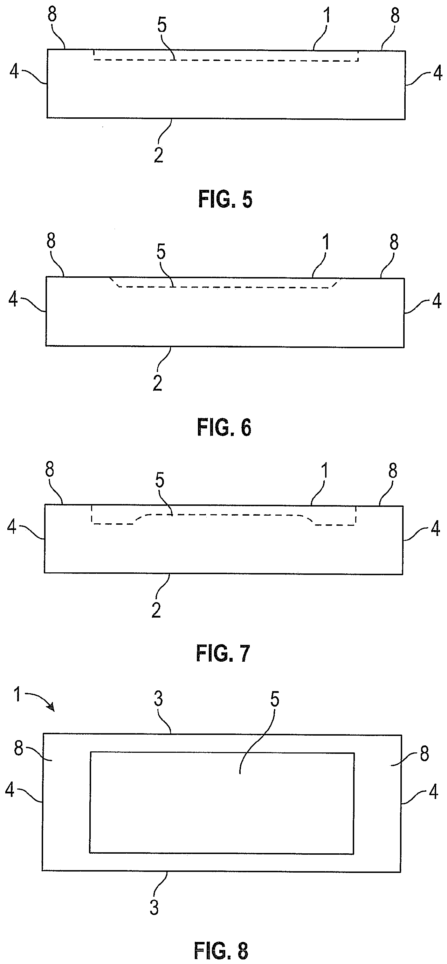

Figure 5 shows a longitudinal view of the evaporation boat of Figures 3 and 4. The cavity 5 is indicated by the dotted line and is in the central region of the evaporation boat where metal is evaporated from. The cavity 5 does not extend into the clamping regions adjacent to the clamping surfaces 4.

Figures 6 and 7 show longitudinal views of further embodiments of an evaporation boat as disclosed herein. The cross-sectional view of Figures 6 and 7 corresponds to Figure 3. The cavity 5 of the evaporation boat of Figure 6 is sloping upwards towards the clamping regions 8. The cavity of the evaporation boat of Figure 7 is deeper at the two ends of the cavity near the clamping regions 8 than in the central region of the evaporation boat.

Figure 8 shows a plan view of the upper side of the evaporation boats of Figures 5 to 7, with the cavity 5 for taking the liquid metal to be evaporated.

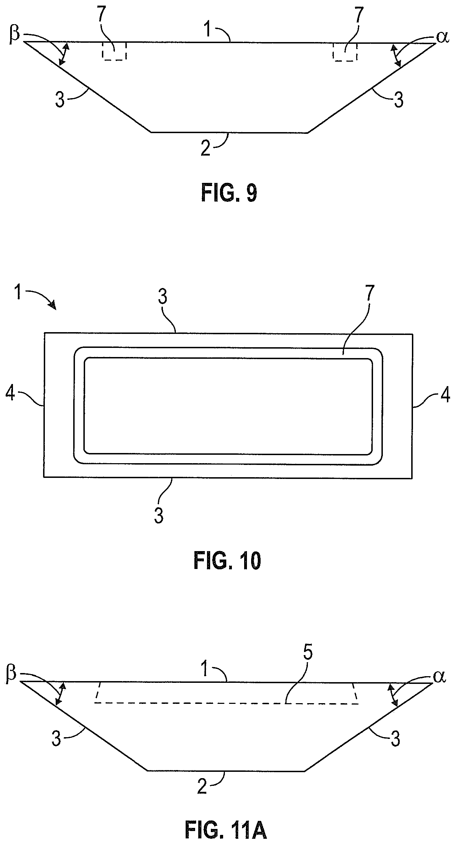

Figure 9 shows a cross-sectional view of a further embodiment of an evaporation boat as disclosed herein, in a direction parallel to the clamping surfaces. Figure 10 shows a plan view of the upper side 1 of the evaporation boat of Figure 9. Metal is evaporated from the upper side 1. The cross-sectional area of the evaporation boat has a trapezoidal shape in a direction parallel to the clamping surfaces along the complete length of the evaporation boat. The upper side 1 of the evaporation boat is parallel to the underside 2 of the evaporation boat. The two clamping surfaces 4 of the evaporation boat are parallel to each other. Each of the two lateral surfaces 3 of the evaporation boat is inclined at an angle α and at an angle β, respectively, of from 30 to less than 45 degrees against the upper side 1 of the evaporation boat. In the example of Figures 9 and 10, the angle α is equal to the angle β and is 35°. The upper side 1 of the evaporation boat of Figures 9 and 10 has a peripheral groove 7 which is oriented parallelly to the lateral surfaces 3 and parallelly to the clamping surfaces 4. The corners of the rectangular-shaped peripheral groove may be rounded. The groove may have a depth of from 2 to 5 mm and a width of from 1 to 5 mm.

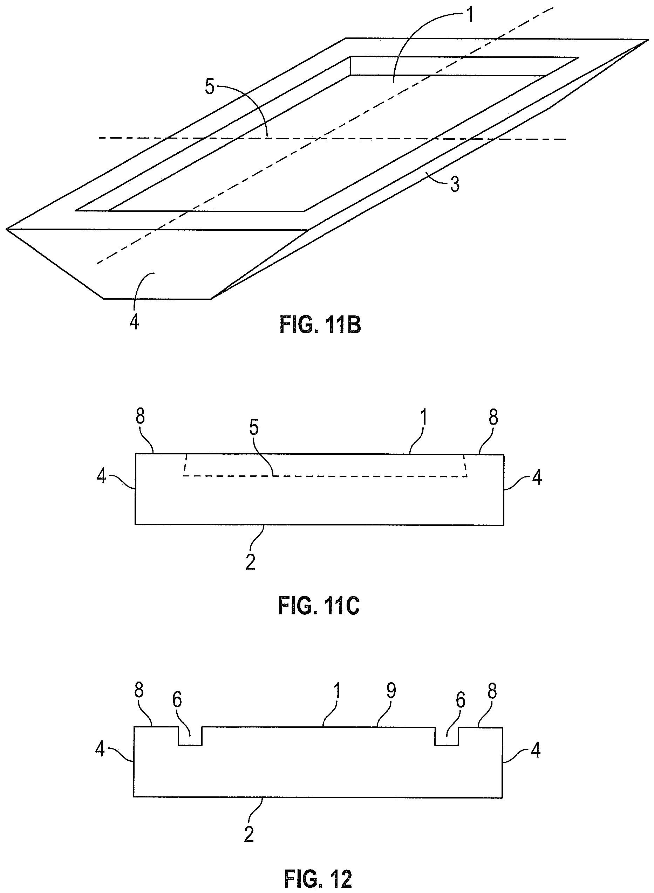

Figure 11A shows a plan view of a further embodiment of an evaporation boat as disclosed herein, in a direction parallel to the clamping surfaces. Figure 11B shows a 3D view of the evaporation boat of Figure 11A. Figure 11C shows a longitudinal view of the evaporation boat of Figures 11A and 11B. Metal is evaporated from the upper side 1. The cross-sectional area of the evaporation boat has a trapezoidal shape in a direction parallel to the clamping surfaces along the complete length of the evaporation boat. The upper side 1 of the evaporation boat is parallel to the underside 2 of the evaporation boat. The two clamping surfaces 4 of the evaporation boat are parallel to each other. Each of the two lateral surfaces 3 of the evaporation boat is inclined at an angle α and at an angle β, respectively, of from 30 to less than 45 degrees against the upper side 1 of the evaporation boat. In the example of Figures 1 and 2, the angle α is equal to the angle β and is 35°. As can be seen from Figure 11B, the evaporation boat has a cavity. In Figures 11A and 11C, the cavity is indicated by the dotted line and is in the central region of the evaporation boat where metal is evaporated from. The cavity does not extend into the clamping regions adjacent to the clamping surfaces 4. The cavity is formed with an undercut at the longer sides parallel to the lateral surfaces of the evaporation boat and at the smaller sides parallel to the clamping surfaces and near the clamping regions 8. The angle which is enclosed by the upper side 1 of the evaporation boat and the cavity 5 may be from 60 to 90°. By this form of the cavity, a homogeneous and complete wetting is achieved in the surface area defined by the cavity. Metal to be evaporated is kept in this area and cannot flow into the clamping regions.

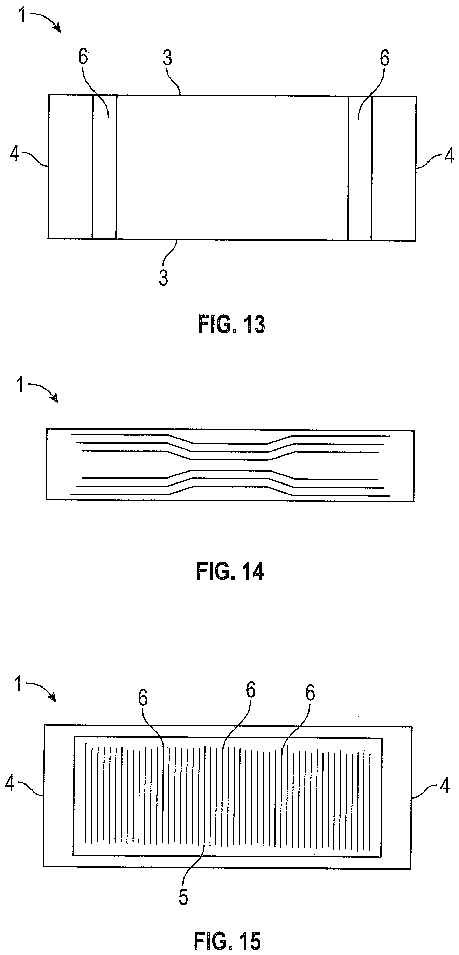

Figure 12 shows a longitudinal view of a further embodiment of an evaporation boat as disclosed herein. Figure 13 shows a plan view of the upper side of the evaporation boat of Figure 12. The cross-sectional area of the evaporation boat has a trapezoidal shape along the complete length of the evaporation boat. Each of the two lateral surfaces 3 of the evaporation boat is inclined at an angle of from 30 to less than 45 degrees against the upper side 1 of the evaporation boat. The upper side 1 of the evaporation boat has two grooves 6 in a direction parallel to the clamping surfaces 4. The grooves 6 are near the clamping regions 8 of the evaporation boat. The grooves may have a width of from 2 to 10 mm and a depth of from 2 to 5 mm. In the central region 9 between the two grooves 6 and in the clamping regions 8, the cross-sectional view of the evaporation boat has a trapezoidal shape and corresponds to the cross-sectional view of Figure 1.

At the positions of the grooves 6 near the clamping regions 8, the temperature of the evaporation boat during operation is higher than in the central region of the evaporation boat, with the consequence that metal is evaporated at the positions of the grooves before flowing into the clamping regions.

Figure 14 shows a plan view of the upper side 1 of a further embodiment of an evaporation boat as disclosed herein. The cross-sectional area of the evaporation boat has a trapezoidal shape along the complete length of the evaporation boat. The cross-sectional view of the evaporation boat of Figure 14 corresponds to the cross-sectional view of Figure 1. Each of the two lateral surfaces 3 of the evaporation boat is inclined at an angle of from 30 to less than 45 degrees against the upper side 1 of the evaporation boat. The upper side of the evaporation boat is modified and structured by a laser beam in such a way that a plurality of lines with a direction substantially parallel to the lateral surfaces extends over the upper side of the evaporation boat. The modification of the upper side of the evaporation boat by a laser beam is improving the initial wetting behavior of the evaporation boat.

Figure 15 shows a plan view of the upper side of a further embodiment of an evaporation boat as disclosed herein. The cross-sectional area of the evaporation boat has a trapezoidal shape along the complete length of the evaporation boat. The cross-sectional view of the evaporation boat of Figure 15 corresponds to the cross-sectional view of Figure 3. The longitudinal view of the evaporation boat of Figure 15 corresponds to the longitudinal view of Figure 5. Each of the two lateral surfaces 3 of the evaporation boat is inclined at an angle of from 30 to less than 45 degrees against the upper side 1 of the evaporation boat. The evaporation boat of Figure 15 has a cavity 5 for the liquid metal in the central region of the evaporation boat. The evaporation boat of Figure 15 has a plurality of grooves 6 in a direction parallel to the clamping surfaces 4 which extend over the central region of the upper side. These grooves 6 serve for improving the initial wetting behavior of the evaporation boat.

The material from which the evaporation boat disclosed herein is made comprises titanium diboride and boron nitride. In some embodiments, the material from which the evaporation boat is made comprises also aluminum nitride. The titanium diboride content of the material from which the evaporation boat is made typically ranges from 30 to 40 vol.-%.

The volume of the evaporation boat disclosed herein typically ranges from about 25 cm³ to 85 cm³.

The evaporation boats disclosed herein can be produced by conventional methods such as hot-pressing a powder mixture comprising titanium diboride and boron nitride into a hot-pressed body and machining the evaporation boats from the hot-pressed bodies. The evaporation boats with the trapezoidal cross-sectional area can be produced by machining, such as sawing. The upper side of the evaporation boat where metal is evaporated from can be produced by machining, such as grinding and milling and the like.

The edges of the evaporation boat as disclosed herein may be chamfered, i.e. rounded, according to common practice for ceramic materials.

The evaporation boat as disclosed herein is used for evaporating metals selected from the group consisting of aluminum, copper and silver. In some embodiments of the present disclosure, the evaporation boat is used for evaporating aluminum for transparent aluminum oxide (AlOₓ) coatings.

### Examples

### Examples 1 to 3 (EX1 to EX3) and Comparative Example 1 (CEX1)

Evaporation boats according to the present disclosure as shown in Figures 3 and 4 were prepared and tested in an industrial web coater (Leybold Optics, Model Type PAK 2500 T+) under the typical conditions of a standard web coating process for evaporation of aluminum. The trapezoidal angle of the evaporation boats was 30° (Example 1), 35° (Example 2) and 40° (Example 3), respectively.

For comparison, evaporation boats having a trapezoidal cross-sectional area with an angle of 45° were also tested (Comparative Example 1). The dimensions of all tested evaporation boats were 9 × 35 × 130 mm. The evaporation boats had a cavity with dimensions 1 × 30 × 120 mm. All evaporation boats were produced from one lot from a powder mixture comprising titanium diboride and boron nitride, with a titanium diboride content of 48.6 wt.-%.

The amount of aluminum evaporated was increased gradually during the total metallizing time of 60 minutes. For each trapezoidal angle of the cross-sectional area of the evaporation boats, three boats were used for metallizing.

The results achieved for power consumption are shown in Table 1. Power consumption for Comparative Example 1 is set to 100% as a reference. Power consumption for Examples 1 to 3 is expressed as percentage of power consumption of Comparative Example 1. The alu rate is the amount of aluminum which is fed to the boat in one minute. The values in Table 1 for power consumption for a specific alu rate are the mean values for three evaporation boats over the whole time when this specific alu rate was run (e.g., 3.8 g/min, as indicated in Table 1). The values for average power consumption and average energy saving in the last two rows of Table 1 are the mean values of the four individual alu rates of Table 1.

**Table 1:**

| Alu Rate [g/min] | EX1 Power consumption [% of CEX1] | EX2 Power consumption [% of CEX1] | EX3 Power consumption [% of CEX1] | CEX1 Power consumption [= 100% as reference] |
|---|---|---|---|---|
| 3.8 | 91 | 92 | 100 | 100 |
| 4.2 | 92 | 94 | 96 | 100 |
| 5.5 | 94 | 95 | 96 | 100 |
| 7.6 | 97 | 104 | 99 | 100 |
| | | | | |
| Average power consumption | 93 | 96 | 98 | |
| Average energy saving | 7 | 4 | 2 | |

### Examples 4 to 6 (EX4 to EX6) and Comparative Example 2 (CEX2)

Evaporation boats according to the present disclosure as shown in Figures 3 and 4 were prepared and tested in an industrial web coater (Applied Materials, Model Type TopMet 2450 HiRes) under the typical conditions of a standard web coating process for evaporation of aluminum. The trapezoidal angle of the evaporation boats was 30° (Example 4), 35° (Example 5) and 40° (Example 6), respectively.

For comparison, an evaporation boat having a trapezoidal cross-sectional area with an angle of 45° was also tested (Comparative Example 2). The dimensions of all tested evaporation boats were 9 × 35 × 130 mm. The evaporation boats had a cavity with dimensions 1 × 30 × 120 mm. All evaporation boats were produced from one lot from a powder mixture comprising titanium diboride and boron nitride, with a titanium diboride content of 48.6 wt.-%.

The amount of aluminum evaporated was increased gradually during the total metallizing time of 60 minutes. For each trapezoidal angle of the cross-sectional area of the evaporation boats, three boats were used for metallizing.

The results achieved for power consumption are shown in Table 2. Power consumption for Comparative Example 2 is indicated in Watt in Table 2 and is set to 100% as a reference. Power consumption for Examples 4 to 6 is indicated in Watt in Table 2 and is also expressed as percentage of power consumption of Comparative Example 2. The alu rate is the amount of aluminum which is fed to the boat in one minute. The values in Table 2 for power consumption for a specific alu rate are the mean values for three evaporation boats over the whole time when this specific alu rate was run (e.g., 4.5 g/min, as indicated in Table 2). The values for average power consumption and average energy saving in the last two rows of Table 2 are the mean values of the four individual alu rates of Table2.

**Table 2**

| Alu rate | EX4 Power consumption | | EX5 Power consumption | | EX6 Power consumption | | CEX2 Power consumption |
|---|---|---|---|---|---|---|---|
| [g/min] | [W] | [% of CEX2] | [W] | [% of CEX2] | [W] | [% of CEX2] | [W] |
| 4.5 | 5949 | 90 | 6161 | 93 | 6425 | 97 | 6637 |
| 6.2 | 6446 | 89 | 6672 | 92 | 6932 | 95 | 7259 |
| 6.9 | 6747 | 92 | 6953 | 94 | 7214 | 98 | 7363 |
| 7.6 | 6900 | 90 | 7183 | 94 | 7464 | 98 | 7631 |
| 8.3 | 7288 | 94 | 7343 | 94 | 7614 | 98 | 7787 |
| 9.0 | 7757 | 97 | 7697 | 96 | 7889 | 99 | 7985 |
| 9.7 | 7802 | 95 | 7854 | 96 | 7996 | 97 | 8211 |
| | | | | | | | |
| Average power consumption | | 92 | | 94 | | 97 | |
| Average energy saving | | 8 | | 6 | | 3 | |

The examples demonstrate that energy savings of 2 to 8% could be achieved using evaporation boats as disclosed herein, compared to evaporation boats having a trapezoidal cross-sectional area with an angle of 45° and the same width of the upper side of the evaporation boats.

## Claims

1. Evaporation boat for evaporation of metals, wherein the evaporation boat is made from a material comprising titanium diboride and boron nitride, and wherein the evaporation boat has an upper side (1), an underside (2), two lateral surfaces (3) and two clamping surfaces (4), and wherein metal is evaporated from the upper side (1), and wherein the two clamping surfaces (4) are parallel to each other, and wherein at least one part of the evaporation boat has a cross-sectional area with a trapezoidal shape in a direction parallel to the clamping surfaces (4), and wherein the upper side (1) of the evaporation boat is parallel to the underside (2) of the evaporation boat, **characterized in that** each of the two lateral surfaces (3) of the evaporation boat is inclined at an angle of from 30 to 42 degrees against the upper side (1) of the evaporation boat in the at least one part of the evaporation boat having a cross-sectional area with a trapezoidal shape.

2. The evaporation boat according to claim 1, wherein each of the two lateral surfaces (3) of the evaporation boat is inclined at an angle of from 30 to 40 degrees against the upper side of the evaporation boat.

3. The evaporation boat according to claim 1 or 2, the evaporation boat having a length, a width and a height, wherein the cross-sectional area of the evaporation boat has a trapezoidal shape in a direction parallel to the clamping surfaces along the complete length of the evaporation boat.

4. The evaporation boat according to claim 1 or 2, wherein the evaporation boat comprises two clamping regions (8) adjacent to the clamping surfaces (4) and a central region (9) in a middle part of the evaporation boat between the two clamping regions (8), and wherein metal is evaporated from the upper side (1) of the central region (9), and wherein the at least one part of the evaporation boat having a cross-sectional area with a trapezoidal shape in a direction parallel to the clamping surfaces (4) is in the central region (9) of the evaporation boat.

5. The evaporation boat according to claim 4, wherein the cross-sectional area in the two clamping regions (8) has a rectangular shape in a direction parallel to the clamping surfaces (4).

6. The evaporation boat according to any of claims 1 to 5, wherein one of the two lateral surfaces (3) of the evaporation boat is inclined at an angle α against the upper side (1) of the evaporation boat in the at least one part of the evaporation boat having a cross-sectional area with a trapezoidal shape, and wherein the other one of the two lateral surfaces (3) of the evaporation boat is inclined at an angle β against the upper side (1) of the evaporation boat in the at least one part of the evaporation boat having a cross-sectional area with a trapezoidal shape, and wherein α is equal to β.

7. The evaporation boat according to any of claims 1 to 6, wherein one of the two lateral surfaces (3) of the evaporation boat is inclined at an angle α against the upper side (1) of the evaporation boat in the at least one part of the evaporation boat having a cross-sectional area with a trapezoidal shape, and wherein the other one of the two lateral surfaces (3) of the evaporation boat is inclined at an angle β against the upper side (1) of the evaporation boat in the at least one part of the evaporation boat having a cross-sectional area with a trapezoidal shape, and wherein α is different from β.

8. The evaporation boat according to any of claims 1 to 7, wherein the evaporation boat has a cavity (5) on the upper side (1) of the evaporation boat, and wherein metal is evaporated from the cavity (5).

9. The evaporation boat according to any of claims 1 to 8, wherein the upper side (1) of the evaporation boat has one or more grooves (6) in a direction parallel to the clamping surfaces (4).

10. The evaporation boat according to any of claims 1 to 9, wherein the upper side (1) of the evaporation boat has a peripheral groove (7) which is oriented parallelly to the lateral surfaces (3) and parallelly to the clamping surfaces (4).

11. The evaporation boat of any of claims 1 to 10, wherein the upper side (1) of the evaporation boat is modified by a laser beam.

12. The evaporation boat of any of claims 1 to 11, wherein the upper side (1) of the evaporation boat is coated at least partially with an inorganic material.

13. The evaporation boat according to any of claims 1 to 12, wherein the material from which the evaporation boat is made is a mixture of titanium diboride, boron nitride and aluminium nitride.

14. The evaporation boat according to any of claims 1 to 13, wherein the evaporation boat is capable of being heated up by direct current flow in a vacuum of 10 milli pascal (10⁻⁴ mbar) to temperatures of 1400 - 1550 °C.

15. Use of the evaporation boat according to any of claims 1 to 14 for evaporating metals selected from the group consisting of aluminum, copper and silver.

## Patentansprüche

1. Verdampferschiffchen zum Verdampfen von Metallen, wobei das Verdampferschiffchen aus einem Material hergestellt ist, das Titandiborid und Bornitrid aufweist, und wobei das Verdampferschiffchen eine Oberseite (1), eine Unterseite (2), zwei Seitenoberflächen (3) und zwei Klemmoberflächen (4) aufweist, und wobei Metall von der Oberseite (1) verdampft wird, und wobei die zwei Klemmoberflächen (4) parallel zueinander sind, und wobei mindestens ein Teil des Verdampferschiffchens eine Querschnittsfläche mit einer Trapezform in einer Richtung parallel zu den Klemmoberflächen (4) aufweist, und wobei die Oberseite (1) des Verdampferschiffchens parallel zur Unterseite (2) des Verdampferschiffchens ist, **dadurch gekennzeichnet, dass** jede der zwei Seitenoberflächen (3) des Verdampferschiffchens in einem Winkel von 30 bis 42 Grad gegen die Oberseite (1) des Verdampferschiffchens in dem mindestens einen Teil des Verdampferschiffchens geneigt ist, der eine Querschnittsfläche mit einer Trapezform aufweist.

2. Das Verdampferschiffchen nach Anspruch 1, wobei jede der zwei Seitenoberflächen (3) des Verdampferschiffchens in einem Winkel von 30 bis 40 Grad gegen die Oberseite des Verdampferschiffchens geneigt ist.

3. Das Verdampferschiffchen nach Anspruch 1 oder 2, wobei das Verdampferschiffchen eine Länge, eine Breite und eine Höhe aufweist, wobei die Querschnittsfläche des Verdampferschiffchens in einer Richtung parallel zu den Klemmoberflächen entlang der gesamten Länge des Verdampferschiffchens eine Trapezform aufweist.

4. Das Verdampferschiffchen nach Anspruch 1 oder 2, wobei das Verdampferschiffchen zwei an die Klemmoberflächen (4) angrenzende Klemmbereiche (8) und einen zentralen Bereich (9) in einem mittleren Teil des Verdampferschiffchens zwischen den zwei Klemmbereichen (8) aufweist, und wobei Metall von der Oberseite (1) des zentralen Bereichs (9) verdampft wird, und wobei der mindestens eine Teil des Verdampferschiffchens, der eine Querschnittsfläche mit einer Trapezform in einer Richtung parallel zu den Klemmoberflächen (4) aufweist, in dem zentralen Bereich (9) des Verdampferschiffchens liegt.

5. Das Verdampferschiffchen nach Anspruch 4, wobei die Querschnittsfläche in den zwei Klemmbereichen (8) in einer zu den Klemmoberflächen (4) parallelen Richtung eine rechteckige Form aufweist.

6. Das Verdampferschiffchen nach einem der Ansprüche 1 bis 5, wobei eine der zwei Seitenoberflächen (3) des Verdampferschiffchens in dem mindestens einen Teil des Verdampferschiffchens, der eine trapezförmige Querschnittsfläche aufweist, in einem Winkel α gegen die Oberseite (1) des Verdampferschiffchens geneigt ist, und wobei die andere der zwei Seitenoberflächen (3) des Verdampferschiffchens in dem mindestens einen Teil des Verdampferschiffchens, der eine trapezförmige Querschnittsfläche aufweist, in einem Winkel β gegen die Oberseite (1) des Verdampferschiffchens geneigt ist, und wobei α gleich β ist.

7. Das Verdampferschiffchen nach einem der Ansprüche 1 bis 6, wobei eine der zwei Seitenoberflächen (3) des Verdampferschiffchens in dem mindestens einen Teil des Verdampferschiffchens, der eine trapezförmige Querschnittsfläche aufweist, in einem Winkel α gegen die Oberseite (1) des Verdampferschiffchens geneigt ist, und wobei die andere der zwei Seitenoberflächen (3) des Verdampferschiffchens in dem mindestens einen Teil des Verdampferschiffchens, der eine trapezförmige Querschnittsfläche aufweist, in einem Winkel β gegen die Oberseite (1) des Verdampferschiffchens geneigt ist, und wobei α von β verschieden ist.

8. Das Verdampferschiffchen nach einem der Ansprüche 1 bis 7, wobei das Verdampferschiffchen an der Oberseite (1) des Verdampferschiffchens eine Kavität (5) aufweist, und wobei Metall aus der Kavität (5) verdampft wird.

9. Das Verdampferschiffchen nach einem der Ansprüche 1 bis 8, wobei die Oberseite (1) des Verdampferschiffchens eine oder mehrere Nuten (6) in einer Richtung parallel zu den Klemmoberflächen (4) aufweist.

10. Das Verdampferschiffchen nach einem der Ansprüche 1 bis 9, wobei die Oberseite (1) des Verdampferschiffchens eine umlaufende Nut (7) aufweist, die parallel zu den Seitenoberflächen (3) und parallel zu den Klemmoberflächen (4) ausgerichtet ist.

11. Das Verdampferschiffchen nach einem der Ansprüche 1 bis 10, wobei die Oberseite (1) des Verdampferschiffchens durch einen Laserstrahl modifiziert ist.

12. Das Verdampferschiffchen nach einem der Ansprüche 1 bis 11, wobei die Oberseite (1) des Verdampferschiffchens mindestens teilweise mit einem anorganischen Material beschichtet ist.

13. Das Verdampferschiffchen nach einem der Ansprüche 1 bis 12, wobei das Material, aus dem das Verdampferschiffchen hergestellt ist, eine Mischung aus Titandiborid, Bornitrid und Aluminiumnitrid ist.

14. Das Verdampferschiffchen nach einem der Ansprüche 1 bis 13, wobei das Verdampferschiffchen durch direkten Stromdurchgang in einem Vakuum von 10 Millipascal (10⁻⁴ mbar) auf Temperaturen von 1400 - 1550 °C aufgeheizt werden kann.

15. Verwendung des Verdampferschiffchens nach einem der Ansprüche 1 bis 14 zum Verdampfen von Metallen, ausgewählt aus der Gruppe bestehend aus Aluminium, Kupfer und Silber.

## Revendications

1. Nacelle d'évaporation pour l'évaporation de métaux, la nacelle d'évaporation étant fabriquée à partir d'un matériau comprenant du diborure de titane et du nitrure de bore, et la nacelle d'évaporation ayant un côté supérieur (1), un côté inférieur (2), deux surfaces latérales (3) et deux surfaces de serrage (4), et dans laquelle du métal est évaporé à partir du côté supérieur (1), et dans laquelle les deux surfaces de serrage (4) sont parallèles l'une à l'autre, et dans laquelle au moins une partie de la nacelle d'évaporation a une aire en coupe transversale avec une forme trapézoïdale dans une direction parallèle aux surfaces de serrage (4), et dans laquelle le côté supérieur (1) de la nacelle d'évaporation est parallèle au côté inférieur (2) de la nacelle d'évaporation, **caractérisée en ce que** chacune des deux surfaces latérales (3) de la nacelle d'évaporation est inclinée selon un angle allant de 30 à 42 degrés par rapport au côté supérieur (1) de la nacelle d'évaporation dans l'au moins une partie de la nacelle d'évaporation ayant une aire en coupe transversale avec une forme trapézoïdale.

2. Nacelle d'évaporation selon la revendication 1, dans laquelle chacune des deux surfaces latérales (3) de la nacelle d'évaporation est inclinée selon un angle allant de 30 à 40 degrés par rapport au côté supérieur de la nacelle d'évaporation.

3. Nacelle d'évaporation selon la revendication 1 ou 2, la nacelle d'évaporation ayant une longueur, une largeur et une hauteur, dans laquelle l'aire en coupe transversale de la nacelle d'évaporation a une forme trapézoïdale dans une direction parallèle aux surfaces de serrage le long de la longueur complète de la nacelle d'évaporation.

4. Nacelle d'évaporation selon la revendication 1 ou 2, la nacelle d'évaporation comprenant deux régions de serrage (8) adjacentes aux surfaces de serrage (4) et une région centrale (9) dans une partie médiane de la nacelle d'évaporation entre les deux régions de serrage (8), et dans laquelle du métal est évaporé à partir du côté supérieur (1) de la région centrale (9), et dans laquelle l'au moins une partie de la nacelle d'évaporation ayant une aire en coupe transversale avec une forme trapézoïdale dans une direction parallèle aux surfaces de serrage (4) est dans la région centrale (9) de la nacelle d'évaporation.

5. Nacelle d'évaporation selon la revendication 4, dans laquelle l'aire en coupe transversale dans les deux régions de serrage (8) a une forme rectangulaire dans une direction parallèle aux surfaces de serrage (4).

6. Nacelle d'évaporation selon l'une quelconque des revendications 1 à 5, dans laquelle l'une des deux surfaces latérales (3) de la nacelle d'évaporation est inclinée selon un angle α par rapport au côté supérieur (1) de la nacelle d'évaporation dans l'au moins une partie de la nacelle d'évaporation ayant une aire en coupe transversale avec une forme trapézoïdale, et dans laquelle l'autre des deux surfaces latérales (3) de la nacelle d'évaporation est inclinée selon un angle β par rapport au côté supérieur (1) de la nacelle d'évaporation dans l'au moins une partie de la nacelle d'évaporation ayant une aire en coupe transversale avec une forme trapézoïdale, et dans laquelle α est égal à β.

7. Nacelle d'évaporation selon l'une quelconque des revendications 1 à 6, dans laquelle l'une des deux surfaces latérales (3) de la nacelle d'évaporation est inclinée selon un angle α par rapport au côté supérieur (1) de la nacelle d'évaporation dans l'au moins une partie de la nacelle d'évaporation ayant une aire en coupe transversale avec une forme trapézoïdale, et dans laquelle l'autre des deux surfaces latérales (3) de la nacelle d'évaporation est inclinée selon un angle β par rapport au côté supérieur (1) de la nacelle d'évaporation dans l'au moins une partie de la nacelle d'évaporation ayant une aire en coupe transversale avec une forme trapézoïdale, et dans laquelle α est différent de β.

8. Nacelle d'évaporation selon l'une quelconque des revendications 1 à 7, la nacelle d'évaporation ayant une cavité (5) sur le côté supérieur (1) de la nacelle d'évaporation, et dans laquelle du métal est évaporé à partir de la cavité (5).

9. Nacelle d'évaporation selon l'une quelconque des revendications 1 à 8, dans laquelle le côté supérieur (1) de la nacelle d'évaporation a une ou plusieurs rainures (6) dans une direction parallèle aux surfaces de serrage (4).

10. Nacelle d'évaporation selon l'une quelconque des revendications 1 à 9, dans laquelle le côté supérieur (1) de la nacelle d'évaporation a une rainure périphérique (7) qui est orientée parallèlement aux surfaces latérales (3) et parallèlement aux surfaces de serrage (4).

11. Nacelle d'évaporation selon l'une quelconque des revendications 1 à 10, dans laquelle le côté supérieur (1) de la nacelle d'évaporation est modifié par un faisceau laser.

12. Nacelle d'évaporation selon l'une quelconque des revendications 1 à 11, dans laquelle le côté supérieur (1) de la nacelle d'évaporation est revêtu au moins partiellement d'un matériau inorganique.

13. Nacelle d'évaporation selon l'une quelconque des revendications 1 à 12, dans laquelle le matériau à partir duquel la nacelle d'évaporation est fabriquée est un mélange de diborure de titane, de nitrure de bore et de nitrure d'aluminium.

14. Nacelle d'évaporation selon l'une quelconque des revendications 1 à 13, la nacelle d'évaporation pouvant être chauffée par circulation de courant continu dans un vide de 10 millipascals (10⁻⁴ mbar) jusqu'à des températures de 1400 à 1550 °C.

15. Utilisation de la nacelle d'évaporation selon l'une quelconque des revendications 1 à 14 pour l'évaporation de métaux choisis dans le groupe constitué par aluminium, cuivre et argent.
